# EUROPEAN PATENT SPECIFICATION

(11) **EP 3 979 496 B1**
(45) Date of publication and mention of the grant of the patent: **25.03.2026**
(21) Application number: 20814721.5
(22) Date of filing: 24.04.2020
(51) Int. Cl.: H03H 9/02, H03H 9/17

(54) **BULK ACOUSTIC RESONATOR HAVING SEPARATED ADDITIONAL STRUCTURE AND TOP ELECTRODE, FILTER, AND ELECTRONIC DEVICE**
AKUSTISCHER VOLUMENRESONATOR MIT GETRENNTER ZUSÄTZLICHER STRUKTUR UND OBERER ELEKTRODE, FILTER UND ELEKTRONISCHER VORRICHTUNG
RÉSONATEUR ACOUSTIQUE DE VOLUME AYANT UNE STRUCTURE SUPPLÉMENTAIRE SÉPARÉE ET UNE ÉLECTRODE SUPÉRIEURE, FILTRE ET DISPOSITIF ÉLECTRONIQUE

(30) Priority: 31.05.2019 CN 201910466991
(43) Date of publication of application: 06.04.2022
(73) Proprietor: Tianjin University, Tianjin 300072 (CN); Rofs Microsystem (Tianjin) Co., Ltd, Tianjin 300462 (CN)
(72) Inventor: ZHANG, Menglun, Tianjin 300072 (CN); PANG, Wei, Tianjin 300072 (CN); YANG, Qingrui, Tianjin 300072 (CN)
(74) Representative: Meyer-Dulheuer MD Legal Patentanwälte PartG mbB
(86) International application number: PCT/CN2020/086551
(87) International publication number: WO 2020/238508

(56) References cited:
- CN-A- 101 931 380
- CN-A- 103 051 302
- CN-A- 104 868 871
- CN-A- 109 687 835
- CN-A- 111 010 111
- US-A1- 2010 141 353
- US-A1- 2012 182 090
- US-A1- 2014 111 288
- US-A1- 2014 232 486
- US-A1- 2016 164 488
- US-A1- 2018 294 794

## Description

### TECHNICAL FIELD

Embodiments of the present disclosure relate to the field of semiconductors, in particular to a bulk acoustic wave resonator with an additional structure separated from a top electrode, a filter having the resonator, and electronic equipment having the resonator or filter.

### BACKGROUND

A film bulk acoustic resonator (Film Bulk Acoustic Resonator, referred to as FBAR, also known as a bulk acoustic resonator, referred to as BAW), serving as an MEMS chip, plays an important role in the communication field. An FBAR filter has a small size (µm level), high resonance frequency (GHz), high quality factor (1000), large power capacity, good roll-off effect and other excellent characteristics. The FBAR is gradually replacing traditional surface acoustic wave (SAW) filters and ceramic filters, and plays a great role in the field of wireless communication radio frequency. The high sensitivity advantage of the FBAR filter can also be applied to sensing fields such as biology, physics, and medicine.

The structural main body of the film bulk acoustic resonator is a "sandwich" structure that is composed of electrode-piezoelectric film-electrode. That is, a layer of piezoelectric film material is sandwiched between two metal electrode layers. A sinusoidal signal is input between the two electrodes, such that the FBAR converts the input electrical signal into mechanical resonance by using an inverse piezoelectric effect, and converts the mechanical resonance into an electrical signal for output by using a piezoelectric effect. The film bulk acoustic resonator mainly uses the longitudinal piezoelectric coefficient (d33) of a piezoelectric film to generate the piezoelectric effect, and thus its main working mode is a thickness extensional mode (Thickness Extensional Mode, referred to as TE mode) in the thickness direction.

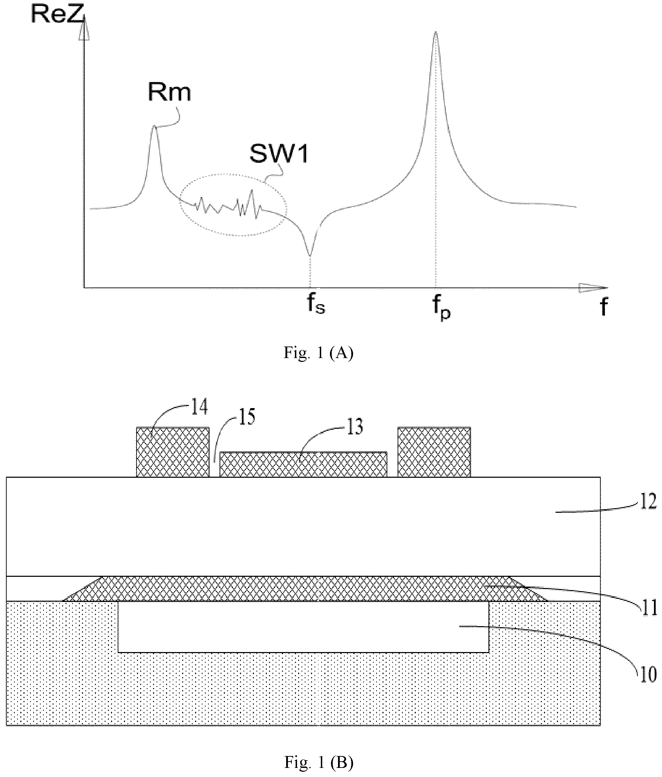

Ideally, the film bulk acoustic resonator only excites the (TE) mode in the thickness direction. However, in addition to the expected TE mode, the film bulk acoustic resonator also generates a lateral parasitic mode, for example, Rayleigh-Lamb mode acoustic waves. These waves in the lateral mode may be lost at the boundary of the resonator, thereby resulting in energy loss of the thickness extensional mode required by the resonator, and finally leading to a decrease in the Q value of the resonator. In order to suppress the leakage of the acoustic waves in the lateral mode at the edge of the resonator, a frame structure (including a protrusion structure and a recess structure) is generally provided at the edge of the top electrode of the resonator, such that the acoustic waves in the lateral mode are limited within an effective region of the resonator to avoid leakage. However, when a voltage is applied to the top electrode and the bottom electrode of the resonator, since the frame structure is connected to the top electrode, the main body portion of the resonator generates main resonance under the piezoelectric effect of the piezoelectric material and also generates secondary resonance in the frame structure during the working of the resonator. Since the resonance frequency of the secondary resonance is different from that of the main resonance, the performance of the filter may be affected, as shown in Fig. 1(A). In the figure, Rm denotes the secondary resonance and SW1 denotes the parasitic mode, and the greater their peak heights are, the greater the negative effect on the performance of the resonator and filter is.

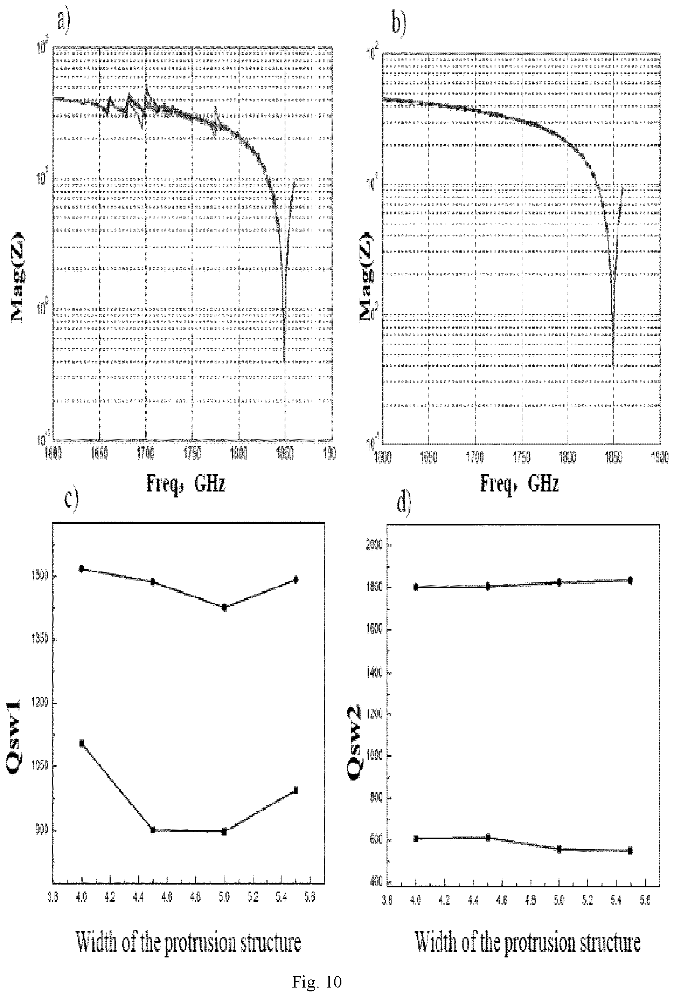

In order to solve this problem, the frame structure is separated from the top electrode in the prior art, that is, there is a void structure therebetween, as indicated by 15 shown in Fig. 1(B). In Fig. 1, 10 represents a cavity structure at the bottom of the resonator, 11 represents the bottom electrode, 12 represents the piezoelectric layer, 13 represents the top electrode, 14 represents the protrusion structure, and 15 represents the void structure between the protrusion structure and the top electrode. The secondary resonance in the protrusion structure is eliminated due to the existence of the void structure 15. However, the Rp value of the resonator may be decreased due to the existence of this structure. Meanwhile, it is not easy to realize such structure during processing. When a void is formed, it is prone to generating an alignment offset.

US 2018/294794 A1 discloses a FBAR with frame structure spaced away from the top electrode by a gap and a non-conductive material covering gap, frame and top electrode.

### SUMMARY

In order to alleviate or solve at least one aspect of the above problems in the prior art, the present disclosure is proposed.

According to an aspect of the invention, a bulk acoustic wave resonator is provided according to independent claim 1.

Alternatively, the non-conductive material layer covers the additional structure and the top electrode from an upper side of the additional structure and the top electrode. Further alternatively, the non-conductive material layer completely covers the top electrode and the additional structure. Further, the non-conductive material layer may be a passivation layer. In an alternative embodiment, the non-conductive material layer is formed with a recess at the gap. Alternatively, a top face of the non-conductive material layer is flush.

Alternatively, the gap has a bottom gap portion at a bottom thereof, two ends of the bottom gap portion respectively extend to a lower side of the additional structure and a lower side of the edge of the top electrode, and the non-conductive material layer at least fills the bottom gap portion. Further alternatively, the additional structure has a first protusion structure on a side close to the top electrode, and the top electrode has a second protrusion structure at the edge thereof, and a width of the first protrusion structure and a width of the second protrusion structure are both within a range from 1 µm to 3 µm.

Alternatively, the top electrode has a top electrode protrusion structure at the edge thereof, and the gap is formed between the top electrode protrusion structure and the additional structure.

Alternatively, a width of the additional structure is greater than 2 µm, and further greater than 5 µm. Alternatively, a thickness of the recess structure of the additional structure is the same as a thickness of the top electrode; and a width of the recess structure of the additional structure is within a range from 1 µm to 3 µm.

Alternatively, a width of the gap is within a range from 0.1 µm to 0.5 µm.

Embodiments of the present disclosure further relate to a filter including the above bulk acoustic wave resonator.

Embodiments of the present disclosure further relate to electronic equipment including the above filter or the above resonator.

The technical solutions of the present disclosure are conducive to ensuring a high Q value and Rp value of the resonator, while effectively eliminating the influence of the secondary resonance therein, so that the performance of the resonator and the filter can be effectively improved.

### BRIEF DESCRIPTION OF DRAWINGS

The following description and drawings can help understand these and other features and advantages in various embodiments disclosed in the present disclosure. The same reference signs in the Figs. always represent the same components, wherein:
Fig. 1A is a schematic diagram of secondary resonance generation in a resonator;
Fig. 1B is a schematic sectional view of a bulk acoustic wave resonator in the prior art;
Fig. 2A is a schematic sectional view of a bulk acoustic wave resonator according to an exemplary embodiment of the present disclosure;
Fig. 2B is a schematic sectional view of a bulk acoustic wave resonator according to an exemplary embodiment of the present disclosure;
Fig. 2C is a schematic sectional view of a bulk acoustic wave resonator according to an exemplary embodiment of the present disclosure;
Fig. 3 is a schematic sectional view of a bulk acoustic wave resonator according to an exemplary embodiment of the present disclosure;
Fig. 4A is a schematic sectional view of a bulk acoustic wave resonator according to an exemplary embodiment of the present disclosure;
Fig. 4B is a schematic sectional view of a bulk acoustic wave resonator according to an exemplary embodiment of the present disclosure;
Fig. 5A is a schematic sectional view of a bulk acoustic wave resonator according to an exemplary embodiment of the present disclosure;
Fig. 5B is a schematic sectional view of a bulk acoustic wave resonator according to the invention;
Fig. 6 is a schematic diagram of simulation results of the Rp value of the bulk acoustic wave resonator in the prior art varying with the width of the gap between the protrusion structure and the top electrode, which illustrates the simulation result of the connection between the protrusion structure and the top electrode and the simulation results of different gap widths between the protrusion structure and the top electrode;
Fig. 7 is a schematic diagram of simulation results of a relationship between widths of protrusion structures and Rp values in bulk acoustic wave resonators with different structures, which illustrates the case where the protrusion structure is connected to a top electrode, the case where a gap is provided between the protrusion structure and the top electrode but the gap is not covered, and the case where a gap is provided between the protrusion structure and the top electrode, and a non-conductive dielectric layer fills the gap and covers the protrusion structure and the top electrode;
Fig. 8 is a schematic diagram of simulation results exemplarily showing influence of different gap widths on an Rp value;
Fig. 9 is a schematic diagram of simulation results exemplarily showing influence of a filling mode of a non-conductive material on an Rp value;
Fig. a) in Fig. 10 shows a frequency (Freq.)-impedance (Mag.) curve of the bulk acoustic wave resonator with a traditional structure, Fig. b) in Fig. 10 shows a frequency-impedance curve of a bulk acoustic wave resonator according to an exemplary embodiment of the present disclosure, Fig. c) in Fig. 10 shows a schematic diagram of a simulation result of a variation condition Qsw1 of a Q value of the resonator (in which the protrusion structure is separated from the top electrode, and the non-conductive dielectric layer fills the gap and completely covers the protrusion structure and the top electrode) within 60 MHz below the frequency of a series resonator, and Fig. d) in Fig. 10 shows a schematic diagram of a simulation result of a variation condition Qsw2 of a Q value of the resonator (in which the protrusion structure is separated from the top electrode, and the non-conductive dielectric layer fills the gap and completely covers the protrusion structure and the top electrode) within 190 MHz below the Qsw1; and

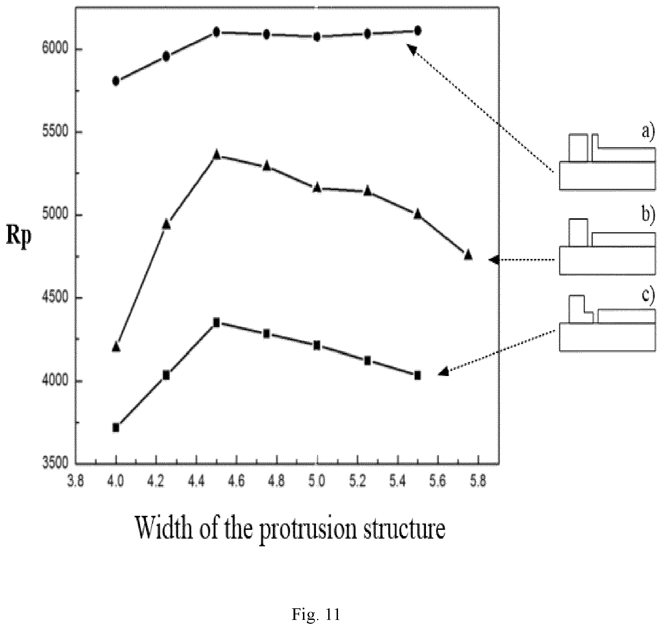

Fig. 11 exemplarily shows a schematic diagram of a simulation structure of a relationship between a width of an additional structure and an Rp based on different structures of the additional structure and the top electrode in the present disclosure.

### DESCRIPTION OF EMBODIMENTS

The technical solutions of the present disclosure will be further described below in detail through embodiments and in conjunction with the drawings. In the specification, the same or similar reference signs indicate the same or similar components. The following description of embodiments of the present disclosure with reference to the drawings is intended to explain the general inventive concept of the present disclosure.

In the present disclosure, a frame structure, i.e. an additional structure mentioned later which includes a recess structure, is provided on an edge of a top electrode of a bulk acoustic wave resonator, and is changed so that acoustic wave energy in a lateral mode in the resonator can be limited within an effective region while the resonator is prone to being processed. Therefore, influence of secondary resonance therein is effectively eliminated while ensuring a high Q value and Rp value of the resonator, thereby effectively improving performance of the resonator and a filter.

In the present disclosure, electrical isolation is realized since there is a gap between the additional structure and the top electrode.

A bulk acoustic wave resonator according to embodiments of the present disclosure will be described below with reference to the drawings. In the bulk acoustic wave resonator, an additional structure is separated from a top electrode to form a gap, and a non-conductive material layer fills the gap and covers at least part of the additional structure and at least part of the top electrode.

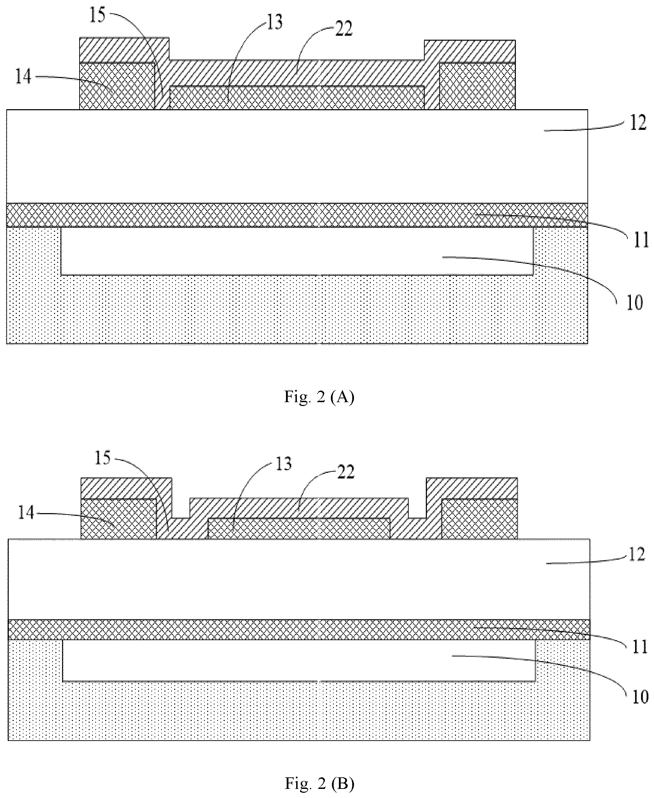

Fig. 2A is a schematic sectional view of a bulk acoustic wave resonator according to an exemplary embodiment of the present disclosure. In the embodiment shown in Fig. 2A, 10 represents an acoustic mirror structure of the resonator, which may be a cavity structure etched in a substrate or a cavity structure protruding upwardly, or may be an acoustic wave reflection form such as a Bragg reflection structure. The acoustic mirror structure is a cavity structure etched in the substrate in Fig. 2A, which is also applicable to other exemplary embodiments of the present disclosure. Furthermore, in Fig. 2A, 11 represents a bottom electrode of the resonator; 12 represents a piezoelectric layer of the resonator; 13 represents a top electrode of the resonator; 14 represents a protrusion structure; and 15 represents a gap between the protrusion structure and the top electrode. Typically, a width of the gap is 0.25 µm, a preferable range is from 0.1 µm to 0.5 µm, and a further optional range is from 0.1 µm to 2 µm. Further, 22 represents a non-conductive dielectric layer that fills the gap 15 and completely covers the protrusion structure 14 and the top electrode 13.

In the embodiment shown in Fig. 2A, the protrusion structure is provided to perform acoustic coupling function. That is, the acoustic impedance in the protrusion structure does not match the acoustic impedance in the effective region of the resonator so that the transmission of acoustic waves is not continuous at the boundary. Therefore, at the boundary, a part of the acoustic energy is coupled and reflected into an effective excitation region, and is then converted into a piston acoustic wave mode perpendicular to a surface of the piezoelectric layer. Accordingly, a Q factor of the resonator is improved.

Meanwhile, since the protrusion structure and the top electrode are electrically insulated from each other and are completely covered by the non-conductive material, an electrical isolation effect can be achieved. Therefore, there is no electric field in the piezoelectric layer under the protrusion structure during working of the resonator, and no secondary resonance is generated. Accordingly, influence of secondary resonance clutters in the resonator can be effectively eliminated. In addition, the protrusion structure and the top electrode are connected by the non-conductive material, so that the effect of acoustic coupling is further improved as compared with a void structure. Accordingly, an Rp value of the resonator is higher than that in the prior art shown in Fig. 1 (B).

Furthermore, it is commonly considered that the greater the width of the protrusion structure is, the higher the Rp value is. However, the parasitic mode and the secondary resonance traditionally become greater as the width of the protrusion structure becomes greater. This design of the structure of the present disclosure avoids or reduces occurrence of the secondary resonance, and the intensity of the parasitic mode is reduced. Therefore, a large-width protrusion structure can be adopted to greatly increase the Rp value, and the secondary resonance may not occur or be reduced. Preferably, the width of the protrusion structure is much greater than 2 µm, and further may be greater than 5 µm.

Fig. 2B is a schematic sectional view of a bulk acoustic wave resonator according to an exemplary embodiment of the present disclosure. The structure of the resonator in Fig. 2B is similar to the structure of Fig. 2A, except that when the width of the void structure 15 is greater, a pit shape is formed on an upper surface of the void (i.e., the gap) during the process of forming the non-conductive dielectric layer 22.

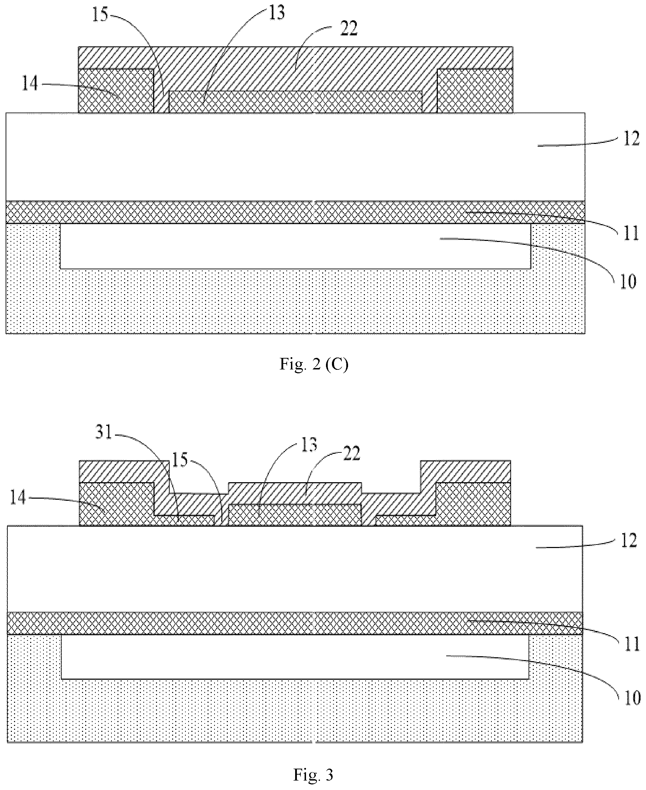

Fig. 2C is a schematic sectional view of a bulk acoustic wave resonator according to an exemplary embodiment of the present disclosure. The structure of the resonator in Fig. 2C is similar to the structure of Fig. 2A, except that a surface of the non-conductive dielectric layer 22 is smooth and flat, and can be processed by a chemical mechanical polishing process.

Fig. 3 is a schematic sectional view of a bulk acoustic wave resonator according to an exemplary embodiment of the present disclosure. The structure of the resonator in Fig. 3 is similar to the structure in Fig. 2A, except that a recess structure 31 is provided around the top electrode. In this embodiment, a thickness of the recess structure is less than a thickness of the top electrode. The existence of the recess structure increases the Qsw value of the resonator, effectively suppresses the parasitic mode in the resonator, and further improves the performance of the resonator.

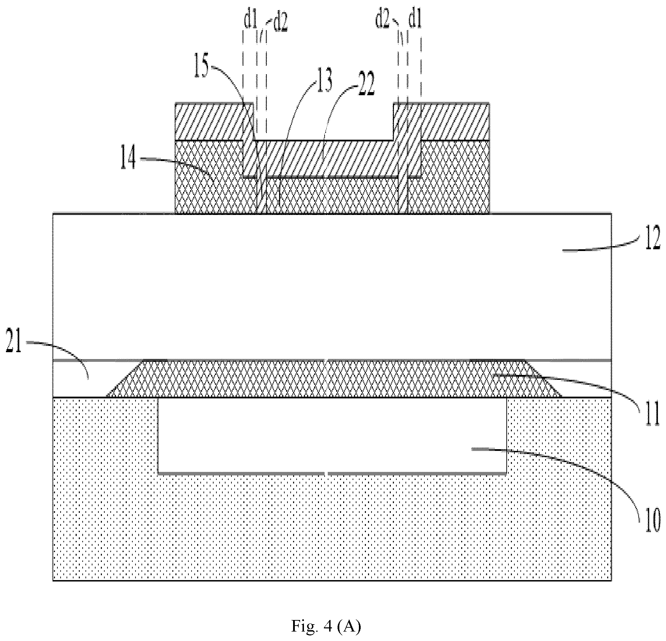

Fig. 4A is a schematic sectional view of a bulk acoustic wave resonator according to an exemplary embodiment of the present disclosure. In Fig. 4A, 10 represents an acoustic mirror structure of the resonator; 11 represents a bottom electrode of the resonator; 21 represents flat layers on both sides of the bottom electrode; 12 represents a piezoelectric layer of the resonator; 13 represents a top electrode of the resonator; 14 represents a protrusion structure, and a recess structure is provided at an inner side of the protrusion structure 14; 15 represents a gap between the protrusion structure and the top electrode; and 22 represents a non-conductive dielectric layer, which fills the gap 15 and completely covers the protrusion structure 14 and the top electrode 13. The gap 15 is typically a width d2 of the gap that is 0.25 µm. The gap 15 is located in the top electrode and spaced apart from the edge of the top electrode by a distance d1, which is typically within a range from 1 µm to 3 µm. In the embodiment of Fig. 4A, it can be understood that the thickness of the recess structure of the additional structure is the same as the thickness of the top electrode.

The processing and manufacturing process of the gap 15 is mainly performed by photoetching and etching. That is, a pattern on a mask is firstly transferred onto a photoresist on the surface of the top electrode by photoetching, a film material at the gap structure is then completely etched by an etching method, and the photoresist is finally removed to form the gap. In the photoetching process, during the process of transferring the pattern on the mask onto the photoresist, the problem of alignment offset is occurred. That is, an alignment mark on the mask is offset from an alignment mark on the substrate such that the position of the ultimately formed gap structure may change. As to the simulation results of Fig. 11, the performance of the resonator where the gap is located on the protrusion structure (i.e., a case a)) is superior to the performance of the resonator where the gap is located on the top electrode (i.e., a case c)).

The conventional structure is not provided with an alignment offset structure. If an offset occurs during the processing, one gap is located on the protrusion structure and another gap is located in the top electrode structure, thereby reducing the performance of the device. The design of this structure of the present disclosure cannot change the final structure of the resonator even if the alignment offset occurs during the processing, so the performance of the resonator cannot be affected.

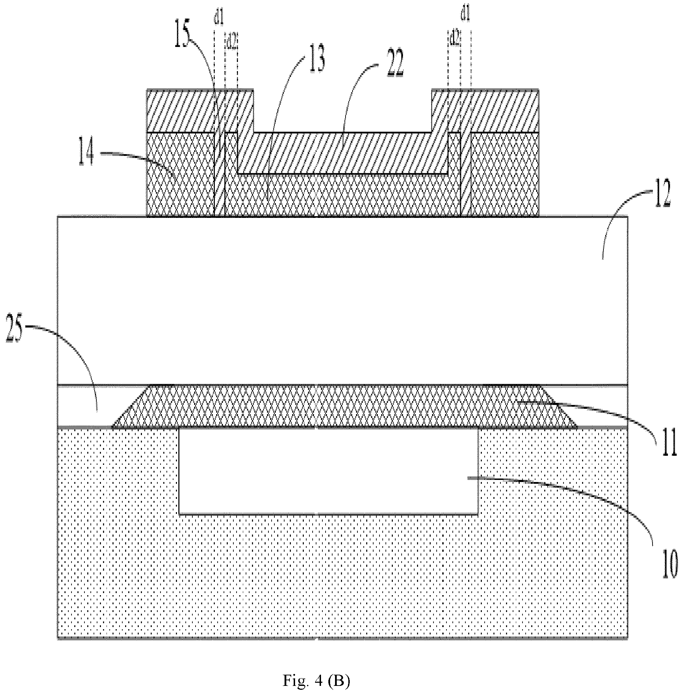

Fig. 4B is a schematic sectional view of a bulk acoustic wave resonator according to an exemplary embodiment of the present disclosure. The structure of the resonator in Fig. 4B is similar to the structure of Fig. 4A, except that the gap 15 is located in the protrusion structure 14 and spaced apart from the edge of the top electrode by a distance d2. Alternatively, it can be understood that in Fig. 4B, the edge of the top electrode is provided with the protrusion structure, and the protrusion structure of the top electrode is spaced apart from the protrusion structure as the additional structure.

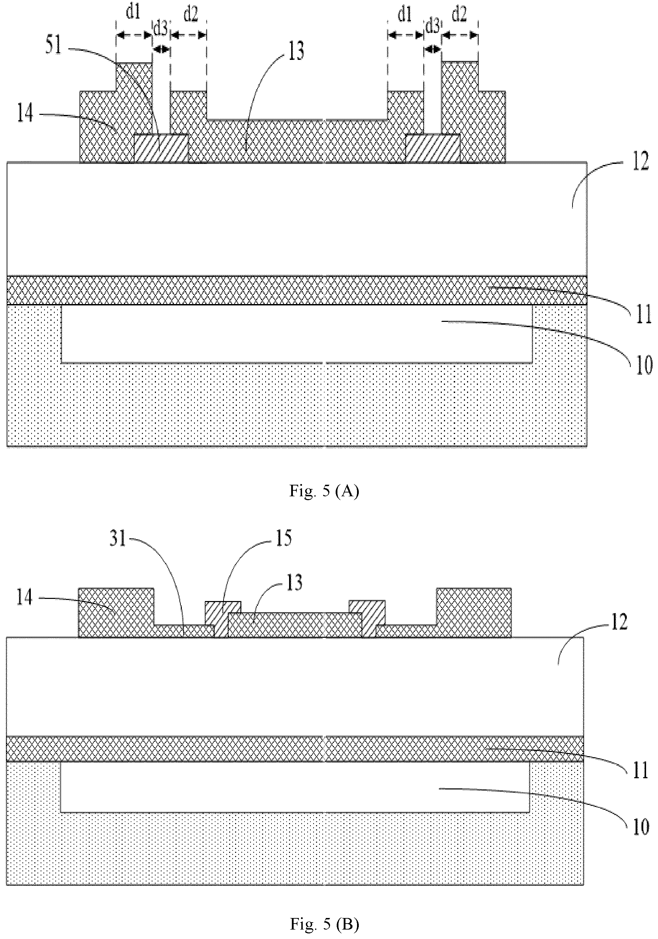

Fig. 5A is a schematic sectional view of a bulk acoustic wave resonator according to an exemplary embodiment of the present disclosure. In Fig. 5A, 10 represents an acoustic mirror structure of the resonator; 11 represents a bottom electrode of the resonator; 12 represents a piezoelectric layer of the resonator; 13 represents a top electrode of the resonator; 14 represents a protrusion structure; and 51 represents a non-conductive dielectric layer (composed of a non-conductive material). The protrusion structure 14 and the top electrode 13 both cross two ends of the non-conductive material layer 15 and are not connected with each other. A width d3 of the gap is typically 0.25 µm, the width d2 of a part of the top electrode crossing the non-conductive dielectric layer and the width d1 of a part of the protrusion structure crossing the non-conductive dielectric layer are both within a range from 1 µm to 3 µm. The design of this structure effectively prevents the influence of the alignment offset on the performance of the device during the processing.

Fig. 5B is a schematic sectional view of a bulk acoustic wave resonator according the invention. In the embodiment shown in Fig. 5B, a non-conductive dielectric material fills the gap 15 and covers a part of a recess structure 31 and a part of the top electrode 13. In this embodiment, a thickness of the recess structure is less than the thickness of the top electrode. The design of this structure effectively prevents the influence of the alignment offset on the performance of the device during the processing.

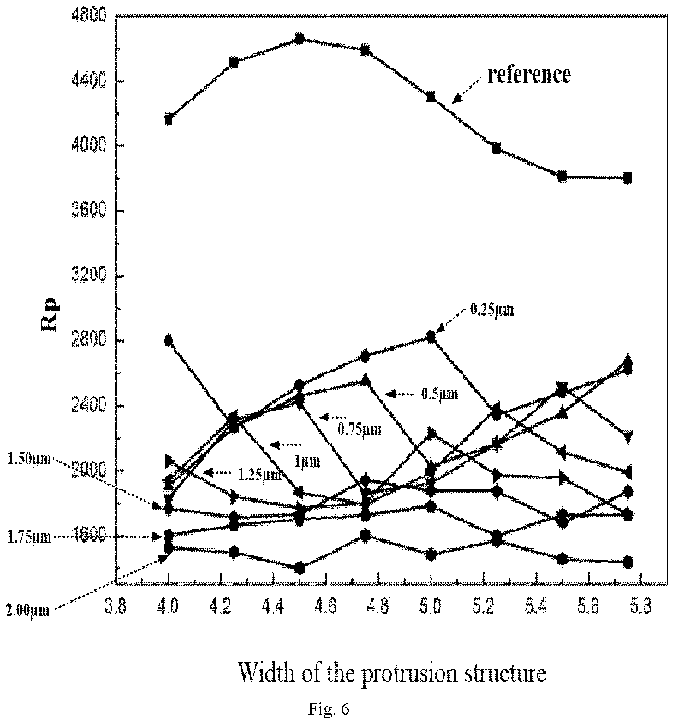

Fig. 6 is a schematic diagram of simulation results of the Rp value of the bulk acoustic wave resonator in the prior art varying with the width of the gap between the protrusion structure and the top electrode. A reference line represents the simulation result of the connection between the protrusion structure and the top electrode, and the remaining lines represent cases where a gap is provided between the protrusion structure and the top electrode. In Fig. 6, a vertical coordinate represents the Rp value of the resonator, and a horizontal coordinate represents the width of the protrusion structure. It can be seen in Fig. 6 that when the gap between the protrusion structure and the top electrode increases from 0 to 2 µm, the Rp value decreases from 4100 to about 1500. That is, the greater the distance between the protrusion structure and the top electrode is, the worse the Rp value is.

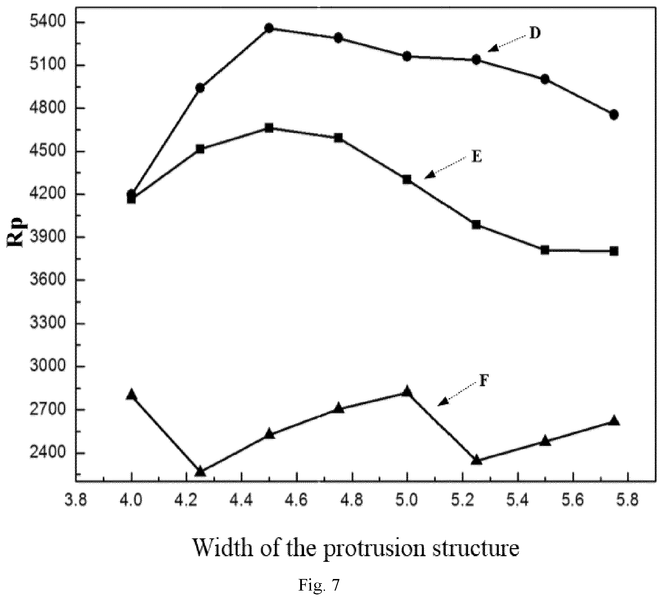

Fig. 7 is a schematic diagram of simulation results of relationships between widths of protrusion structures and Rp values in bulk acoustic wave resonators with different structures. Fig. 7 illustrates a case where the protrusion structure is connected to the top electrode, a case where a gap is provided between the protrusion structure and the top electrode but the gap is not covered, and a case where a gap is provided between the protrusion structure and the top electrode and a passivation layer fills the gap and covers the protrusion structure and the top electrode. In Fig. 7, the resonators of different structures are simulated, and the three simulation results correspond to three structures shown in the figure on the right. It can be seen from the figure that, compared with the case where the protrusion structure is connected to the top electrode, the Rp value of the resonator becomes worse after the protrusion structure is separated from the top electrode. That is, the performance of the resonator in the case where the protrusion structure is separated from the top electrode is worse than the case where the protrusion structure is connected to the top electrode. After the non-conductive material completely covers the protrusion structure and the top electrode and fills the gap therebetween, the Rp value of the resonator is increased. That is, the performance of the resonator in the case where the non-conductive material fills the gap and completely covers the protrusion structure and the top electrode is superior to the performance of the resonator in the case where the protrusion structure is connected to the top electrode.

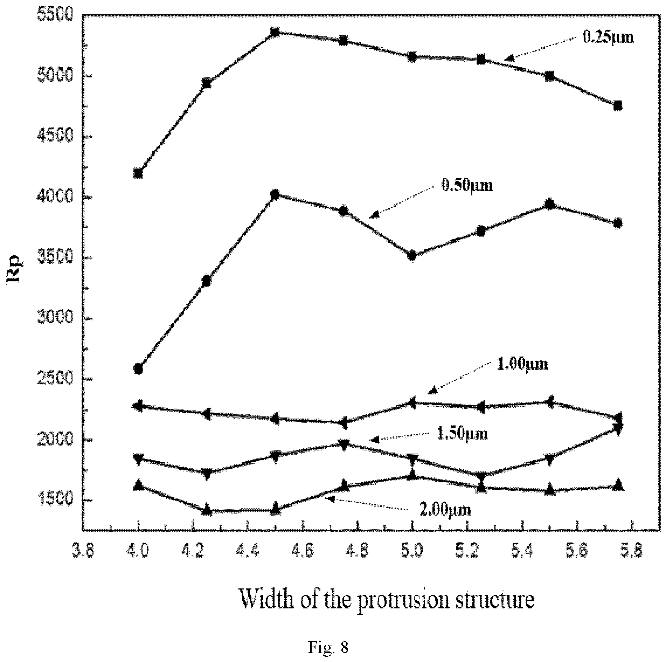

Fig. 8 is a schematic diagram of simulation results exemplarily showing influence of different gap widths on the Rp value. When a passivation layer is provided on the top of the device and configured to fill the gap between the protrusion structure and the top electrode, a simulation calculation is performed in order to verify whether the size of the gap affects the performance of the resonator. It can be seen from Fig. 8 that, when the width of the gap increases from 0.25 µm to 0.5 µm, to 1 µm, to 1.5 µm, and up to 2 µm, the Rp value gradually decreases. Therefore, the greater gap between the protrusion structure and the top electrode is not necessarily superior, and the maximum value of the gap is about 0.25 µm.

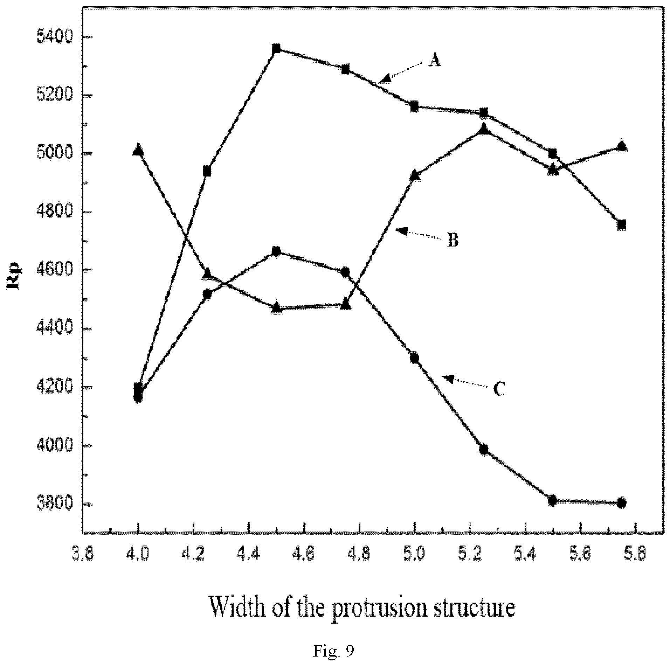

Fig. 9 is a schematic diagram of simulation results exemplarily showing influence of the filling mode of the non-conductive material on the Rp value. It can be seen from Fig. 9 that the Rp value of the resonator can be increased in the case where the non-conductive material only fills the gap between the protrusion structure and the top electrode. However, this effect is not as good as the case where the non-conductive material completely covers the protrusion structure and the top electrode and fills the gap therebetween.

Fig. a) in Fig. 10 shows a frequency (Freq.)-impedance (Mag.) curve of the bulk acoustic wave resonator with the conventional structure, Fig. b) in Fig. 10 shows a frequency-impedance curve of a bulk acoustic wave resonator according to an exemplary embodiment of the present disclosure, Fig. c) in Fig. 10 shows a schematic diagram of a simulation result of Qsw1, and Fig. d) in Fig. 10 shows a schematic diagram of a simulation result of Qsw2. In the impedance-frequency curve of the resonator, Qsw1 denotes the variation condition of the Q value of the resonator within 60 MHz below the frequency of a series resonator, and Qsw2 denotes the variation condition of the Q value of the resonator within 190MHz below Qsw1. The variation conditions of the Q value of the resonator in the Qsw1 and Qsw2 respectively represent the strength of the parasitic mode and the secondary resonance in the resonator. The higher the Q value is, the weaker the strength is.

In Fig. 10a), the resonator with the conventional structure has obvious clutters in the Qsw1 and Qsw2. After the protrusion structure is separated from the top electrode, the non-conductive material fills the gap and covers the protrusion structure and the top electrode and the simulation results are shown in Fig. c) and Fig. d). It can be seen that the Qsw1 and Qsw2 are much higher than those in the conventional structure, that is, the case where the protrusion structure is connected to the top electrode. In other words, the parasitic mode and secondary resonance clutters are significantly suppressed, as shown in Fig. b).

It should be noted that, in the present disclosure, the gap filling not only includes the filling situations shown in Figs. 2A-2C, Fig. 3, Figs. 4A-4B, and Fig. 5B, but also includes the filling situation shown in Fig. 5A. Furthermore, in Fig. 5A, the vertical void portion can also be filled, and these are all within the protection scope of the present disclosure.

Furthermore, although not shown, the present disclosure may only cover at least part of the additional structure or at least part of the top electrode. Compared with the case in the prior art where only the gap is filled and the additional structure and the edge of the top electrode on both sides of the gap are not covered, the resonator of the present disclosure produces advantageous technical effects.

In addition, although not shown, the present disclosure may cover at least part of the additional structure and at least part of the top electrode on the both sides of the gap while covering the gap. Compared with the case in the prior art where only the gap is filled and the additional structure and the edge of the top electrode on the both sides of the gap are not covered, the resonator of the present disclosure produces advantageous technical effects.

Fig. 11 exemplarily illustrates a schematic diagram of a simulation structure of a relationship between a width of an additional structure and an Rp based on different structures of the additional structure and the top electrode in the present disclosure. The case a) in Fig. 11 corresponds to the situation in Fig. 4B, the case b) corresponds to the situation in Fig. 2A, and the case c) corresponds to the situation in Fig. 4A. As shown in Fig. 11, the case in Fig. 4B is the most preferred, the case in Fig. 2A is lest preferred, and the case in Fig. 4A is the last preferred.

In the present disclosure, the material of the electrodes may be gold (Au), tungsten (W), molybdenum (Mo), platinum (Pt), ruthenium (Ru), iridium (Ir), titanium tungsten (TiW), aluminum (Al), titanium (Ti) and other similar metals.

The material of the piezoelectric layer may be aluminum nitride (AlN), zinc oxide (ZnO), lead zirconate titanate (PZT), lithium niobate (LiNbO₃), quartz (Quartz), potassium niobate (KNbO₃) or lithium tantalate (LiTaO₃), or other materials.

The material of the non-conductive dielectric layer may be composed of non-conductive materials such as silicon dioxide, aluminum nitride, silicon nitride, silicon carbide, resin, and rubber.

Although not shown, embodiments of the present disclosure further relate to a filter including the above bulk acoustic wave resonator.

Embodiments of the present disclosure further relate to electronic equipment including the above resonator or the above filter.

Although the embodiments of the present disclosure have been illustrated and described, it can be understood for those skilled in the art that modifications can be made to these embodiments without departing from the scope of the present disclosure, which defined by the appended claims

## Claims

1. A bulk acoustic wave resonator, comprising:
a substrate;
an acoustic mirror (10);
a bottom electrode (11) provided above the substrate;
a top electrode (13) provided with an electrode connection portion; and
a piezoelectric layer (12) provided above the bottom electrode (11) and arranged between the bottom electrode (11) and the top electrode (13),
wherein the resonator further comprises an additional structure (14) provided on the piezoelectric layer (12), and the additional structure (14) is spaced apart from an edge of the top electrode (13) by a gap (15);
wherein the resonator further comprises a non-conductive material layer (22), the non-conductive material layer (22) fills the gap (15) and covers at least part of the additional structure (14) and/or at least part of the top electrode (13);
**characterized in that** at least part of the additional structure (14) has a recess structure (31) on a side close to the top electrode (13).

2. The resonator according to claim 1, wherein the non-conductive material layer (22) covers the additional structure (14) and the top electrode (13) from an upper side of the additional structure (14) and the top electrode (13).

3. The resonator according to claim 2, wherein the non-conductive material layer (22) completely covers the top electrode (13) and the additional structure (14).

4. The resonator according to claim 3, wherein the non-conductive material layer (22) is a passivation layer.

5. The resonator according to any one of claims 2-4, wherein the non-conductive material layer (22) is formed with a recess at the gap (15).

6. The resonator according to claim 3 or 4, wherein a top face of the non-conductive material layer (22) is flush.

7. The resonator according to claim 1, wherein the gap (15) has a bottom gap portion at a bottom thereof, two ends of the bottom gap portion respectively extend to a lower side of the additional structure (14) and a lower side of the edge of the top electrode (13), and the non-conductive material layer at least fills the bottom gap portion.

8. The resonator according to claim 7, wherein the additional structure (14) has a first protrusion structure on a side close to the top electrode (13), and the top electrode (13) has a second protrusion structure at the edge thereof; and a width of the first protrusion structure and a width of the second protrusion structure are both within a range from 1 µm to 3 µm.

9. The resonator according to any one of claims 1-6, wherein the top electrode (13) has a top electrode protrusion structure at the edge thereof, and the gap (15) is formed between the top electrode protrusion structure and the additional structure (14).

10. The resonator according to claim 1, wherein a width of the additional structure (14) is greater than 2 µm.

11. The resonator according to claim 1, wherein a thickness of the recess structure of the additional structure (14) is the same as a thickness of the top electrode (13); and
a width of the recess structure of the additional structure (14) is within a range from 1 µm to 3 µm.

12. The resonator according to any one of claims 1-11, wherein a width of the gap (15) is within a range from 0.1 µm to 0.5 µm.

13. A filter, comprising the bulk acoustic wave resonator according to any one of claims 1-12.

14. An electronic equipment, comprising the filter according to claim 13 or the resonator according to any one of claims 1-12.

## Patentansprüche

1. Bulk-Akustikwellenresonator, umfassend:
ein Substrat;
einen akustischen Spiegel (10);
eine untere Elektrode (11), die über dem Substrat vorgesehen ist;
eine obere Elektrode (13), die mit einem Elektrodenanschlussabschnitt versehen ist; und
eine piezoelektrische Schicht (12), die über der unteren Elektrode (11) vorgesehen und zwischen der unteren Elektrode (11) und der oberen Elektrode (13) angeordnet ist,
wobei der Resonator ferner eine zusätzliche Struktur (14) aus einem nichtleitenden Material umfasst, die auf der piezoelektrischen Schicht (12) vorgesehen ist, und die zusätzliche Struktur (14) durch einen Spalt (15) von einer Kante der oberen Elektrode (13) beabstandet ist;
wobei der Resonator ferner eine Schicht (22) aus nichtleitendem Material umfasst, wobei die Schicht (22) aus nichtleitendem Material den Spalt (15) ausfüllt und mindestens einen Teil der zusätzlichen Struktur (14) und/oder mindestens einen Teil der oberen Elektrode (13) bedeckt;
**dadurch gekennzeichnet, dass** zumindest ein Teil der zusätzlichen Struktur (14) eine Aussparungsstruktur 31 auf einer Seite nahe der oberen Elektrode (13) aufweist.

2. Resonator Bulk-Akustikwellenresonator nach Anspruch 1, wobei die nichtleitende Materialschicht (22) die zusätzliche Struktur (14) und die obere Elektrode (13) von einer Oberseite der zusätzlichen Struktur (14) und der oberen Elektrode (13) aus bedeckt.

3. Bulk-Akustikwellenresonator nach Anspruch 2, wobei die nichtleitende Materialschicht (22) die obere Elektrode (13) und die zusätzliche Struktur (14) vollständig bedeckt.

4. Bulk-Akustikwellenresonator nach Anspruch 3, wobei die nichtleitende Materialschicht (22) eine Passivierungsschicht ist.

5. Bulk-Akustikwellenresonator nach einem der Ansprüche 2 bis 4, wobei die nichtleitende Materialschicht (22) mit einer Aussparung an der Lücke (15) ausgebildet ist.

6. Bulk-Akustikwellenresonator nach Anspruch 3 oder 4, wobei eine Oberseite der Schicht aus nichtleitendem Material (22) bündig ist.

7. Bulk-Akustikwellenresonator nach Anspruch 1, wobei der Spalt (15) einen unteren Spaltabschnitt an seiner Unterseite aufweist, wobei sich die beiden Enden des unteren Spaltabschnitts jeweils bis zur Unterseite der zusätzlichen Struktur (14) und bis zur Unterseite der Kante der oberen Elektrode (13) erstrecken und wobei die nichtleitende Materialschicht zumindest den unteren Spaltabschnitt ausfüllt.

8. Bulk-Akustikwellenresonator nach Anspruch 7, wobei die zusätzliche Struktur (14) eine erste Vorsprungsstruktur auf einer Seite nahe der oberen Elektrode (13) aufweist und die obere Elektrode (13) eine zweite Vorsprungsstruktur an ihrer Kante aufweist; und wobei eine Breite der ersten Vorsprungsstruktur und eine Breite der zweiten Vorsprungsstruktur beide in einem Bereich von 1 µm bis 3 µm liegen.

9. Bulk-Akustikwellenresonator nach einem der Ansprüche 1 bis 6, wobei die obere Elektrode (13) eine obere Elektrodenvorsprungsstruktur an ihrer Kante aufweist und der Spalt (15) zwischen der oberen Elektrodenvorsprungsstruktur und der zusätzlichen Struktur (14) ausgebildet ist.

10. Bulk-Akustikwellenresonator nach Anspruch 1, wobei die Breite der zusätzlichen Struktur (14) größer als 2 µm ist.

11. Bulk-Akustikwellenresonator nach Anspruch 1, wobei die Dicke der Vertiefungsstruktur der zusätzlichen Struktur (14) der Dicke der oberen Elektrode (13) entspricht; und
eine Breite der Vertiefungsstruktur der zusätzlichen Struktur (14) in einem Bereich von 1 µm bis 3 µm liegt.

12. Bulk-Akustikwellenresonator nach einem der Ansprüche 1 bis 11, wobei die Breite des Spalts (15) in einem Bereich von 0,1 µm bis 0,5 µm liegt.

13. Filter, umfassend den Bulk-Akustikwellenresonator nach einem der Ansprüche 1 bis 12.

14. Elektronisches Gerät, umfassend den Filter nach Anspruch 13 oder den Bulk-Akustikwellenresonator nach einem der Ansprüche 1 bis 12.

## Revendications

1. Résonateur à ondes acoustiques de volume, comprenant :
un substrat;
un miroir acoustique (10);
une électrode inférieure (11) prévue au-dessus du substrat;
une électrode supérieure (13) pourvue d'une partie de connexion d'électrode; et
une couche piézoélectrique (12) prévue au-dessus de l'électrode inférieure (11) et disposée entre l'électrode inférieure (11) et l'électrode supérieure (13),
dans lequel le résonateur comprend en outre une structure supplémentaire d' (14) prévue de manièr e sur la couche piézoélectrique (12), et la structure supplémentaire (14) est espacée d'un bord de l'électrode supérieure (13) par un espace (15);
dans lequel le résonateur comprend en outre une couche de matériau non conducteur (22), la couche de matériau non conducteur (22) remplit l'espace (15) et recouvre au moins une partie de la structure supplémentaire (14) et/ou au moins une partie de l'électrode supérieure (13);
**caractérisé en ce qu'**au moins une partie de la structure supplémentaire (14) présente une structure en retrait d' 31 sur un côté proche de l'électrode supérieure (13).

2. Résonateur à ondes acoustiques de volume selon la revendication 1, dans lequel la couche de matériau non conducteur (22) recouvre la structure supplémentaire (14) et l'électrode supérieure (13) depuis un côté supérieur de la structure supplémentaire (14) et de l'électrode supérieure (13).

3. Résonateur à ondes acoustiques de volume selon la revendication 2, dans lequel la couche de matériau non conducteur (22) recouvre complètement l'électrode supérieure (13) et la structure supplémentaire (14).

4. Résonateur à ondes acoustiques de volume selon la revendication 3, dans lequel la couche de matériau non conducteur (22) est une couche de passivation.

5. Résonateur à ondes acoustiques de volume selon l'une quelconque des revendications 2 à 4, dans lequel la couche de matériau non conducteur (22) est formée avec un évidement au niveau de l'espace (15).

6. Résonateur à ondes acoustiques de volume selon la revendication 3 ou 4, dans lequel une face supérieure de la couche de matériau non conducteur (22) est affleurante.

7. Résonateur à ondes acoustiques de volume selon la revendication 1, dans lequel l'espace (15) comporte une partie inférieure au niveau de sa base, les deux extrémités de la partie inférieure s'étendant respectivement vers un côté inférieur de la structure supplémentaire (14) et vers un côté inférieur du bord de l'électrode supérieure (13), et la couche de matériau non conducteur remplissant au moins la partie inférieure.

8. Résonateur à ondes acoustiques de volume selon la revendication 7, dans lequel la structure supplémentaire (14) comporte une première structure en saillie sur un côté proche de l'électrode supérieure (13), et l'électrode supérieure (13) comporte une deuxième structure en saillie au niveau de son bord; et une largeur de la première structure en saillie et une largeur de la deuxième structure en saillie sont toutes deux comprises dans une plage de 1 µm à 3 µm.

9. Résonateur à ondes acoustiques de volume selon l'une quelconque des revendications 1 à 6, dans lequel l'électrode supérieure (13) comporte une structure en saillie d'électrode supérieure au niveau de son bord, et l'espace (15) est formé entre la structure en saillie d'électrode supérieure et la structure supplémentaire (14).

10. Résonateur à ondes acoustiques de volume selon la revendication 1, dans lequel la largeur de la structure supplémentaire (14) est supérieure à 2 µm.

11. Résonateur à ondes acoustiques de volume selon la revendication 1, dans lequel l'épaisseur de la structure en retrait de la structure supplémentaire (14) est la même que l'épaisseur de l'électrode supérieure (13); et
la largeur de la structure en retrait de la structure supplémentaire (14) est comprise dans une plage de 1 µm à 3 µm.

12. Résonateur à ondes acoustiques de volume selon l'une quelconque des revendications 1 à 11, dans lequel la largeur de l'espace (15) est comprise dans une plage de 0,1 µm à 0,5 µm.

13. Filtre comprenant le résonateur à ondes acoustiques de volume selon l'une quelconque des revendications 1 à 12.

14. Équipement électronique, comprenant le filtre selon la revendication 13 ou le Résonateur à ondes acoustiques de volume selon l'une quelconque des revendications 1 à 12.
